# EUROPÄISCHE PATENTSCHRIFT

(11) **EP 3 170 258 B1**
(45) Veröffentlichungstag und Bekanntmachung des Hinweises auf die Patenterteilung: **05.08.2020**
(21) Anmeldenummer: 15728493.6
(22) Anmeldetag: 09.06.2015
(51) Int. Cl.: H03H 1/00

(54) **FILTERANORDNUNG ZUM FILTERN VON PARASITÄREN INDUKTIONSSTRÖMEN, SPANNUNGSWANDLER MIT EINER FILTERANORDNUNG**
FILTER ARRANGEMENT FOR FILTERING PARASITIC INDUCTION CURRENTS, AND VOLTAGE CONVERTER COMPRISING A FILTER ARRANGEMENT
ENSEMBLE DE FILTRAGE POUR LE FILTRAGE DE COURANTS D'INDUCTION PARASITES, CONVERTISSEUR DE TENSION AVEC UN ENSEMBLE DE FILTRAGE

(30) Priorität: 18.07.2014 DE 102014214021
(43) Veröffentlichungstag der Anmeldung: 24.05.2017
(73) Patentinhaber: Conti Temic Microelectronic GmbH, 90411 Nürnberg (DE)
(72) Erfinder: RIDDER, Matthias, 90542 Eckental (DE); UMERSKI, Adam, 90489 Nürnberg (DE)
(74) Vertreter: Bonn, Roman Klemens
(86) Internationale Anmeldenummer: PCT/EP2015/062806
(87) Internationale Veröffentlichungsnummer: WO 2016/008646

(56) Entgegenhaltungen:
- EP-A1- 2 911 295
- WO-A1-2014/122095
- US-A- 5 838 216
- US-A1- 2012 081 097
- US-A1- 2013 154 766
- US-B1- 6 218 913

## Beschreibung

Die vorliegende Erfindung betrifft eine Filteranordnung zum Filtern von parasitären Induktionsströmen. Ferner betrifft die Erfindung einen Stromrichter mit zumindest einer genannten Filteranordnung.

Stromrichter, insbesondere Spannungswandler, werden oft im Leistungselektronikbereich, insbesondere in Bordnetzen von Kraftfahrzeugen, verwendet, in denen hohe Ströme in sehr kurzen Zeiten zwischen verschiedenen Strompfaden umgeschaltet werden. Die schnelle Umschaltung der hohen Ströme erzeugt parasitäre Induktionsströme und folglich elektromagnetische Emissionen, die zu Funktionsstörungen bei den Stromrichtern und bei anderen sich in der Nähe der Stromrichter befindlichen Schaltungskomponenten führen können. In Bordnetzen von Kraftfahrzeugen können derartige elektromagnetische Emissionen zum Ausfall der Bordnetze und sogar zur Manövrierunfähigkeit der Fahrzeuge führen.

Das Dokument US2013/0154766 A1 offenbart ein EMV-Leistungsfilter, das eine Filterschaltung und ein die Filterschaltung umgebendes leitendes Gehäuse umfasst, wobei die Filterschaltung umfasst: mindestens einen elektrischen Leiter, der aus einer Stromschiene zum Tragen einer elektrischen Leistung besteht; mindestens ein ferromagnetisches Element zum Modifizieren der Impedanz des elektrischen Leiters; mindestens einen Kondensator, der elektrisch zwischen dem elektrischen Leiter und dem leitenden Gehäuse verbunden ist.

US6218913 B1 offenbart ein elektromagnetisches Interferenzfilter zum Reduzieren des leitungsgebundenen Rauschens für Wechselstromleitungen, wobei eine kompakte Komponentengeometrie angepasste Materialeigenschaften integriert, um eine Koaxialinduktor- und axialsymmetrische Kondensatorkonfiguration zu erzeugen, die eine verringerte Größe, eine erhöhte Frequenzleistung und eine verbesserte Spannungsisolation gegenüber kann traditionelle Magnetdraht-Konstruktionsmethoden bereitstellt.

US5838216 offenbart eine verbesserte Filteranordnung zum Bereitstellen von mindestens Gleichtaktfilterung. Die Filteranordnung umfasst mehrere voneinander beabstandete elektrische Leiter, um mindestens Gleichtaktstrom zu führen; ein Gehäuse, das elektrisch von der Vielzahl elektrischer Leiter isoliert ist und einen Teil einer Länge der Vielzahl elektrischer Leiter enthält, wobei das Gehäuse einen inneren Hohlraum aufweist, der durch eine Wand mit mindestens einem teilweise elektrisch leitenden Abschnitt definiert ist; mindestens ein induktives Element in einer geschlossenen unteren Reluktanzschleife, die sich um die Vielzahl von elektrischen Leitern erstreckt und davon elektrisch isoliert ist; und mindestens ein kapazitives Element, wobei jedes kapazitive Element einen elektrischen Kontakt mit dem elektrisch leitenden Teil der Wand und der Vielzahl von elektrischen Leitern aufweist, um eine Kapazität zwischen der Vielzahl von elektrischen Leitern und dem elektrisch leitenden Teil der Wand bereitzustellen.

EP2911295 A1 offenbart eine Anordnung und ein Verfahren zum Bereitstellen einer Isolation gegen elektromagnetische Störungen. Die Anordnung umfasst ein Gehäuse mit einer ersten Platte und einer zweiten Platte. Stromschienen erstrecken sich durch die erste und zweite Platte. Eine Montageplatte ist zwischen der ersten Platte und der zweiten Platte positioniert. Auf der Montageplatte befinden sich Positionierungselemente. Mehrere induktive Kerne sind in der Nähe der Positionierungselemente positioniert, wobei die induktiven Kerne Öffnungen aufweisen, durch die sich die Stromschienen erstrecken.

WO2014/122095 A1 offenbart ein Filterkomponent, die einen Gehäusekörper, eine erste und mindestens eine zweite Stromschiene umfasst, die jeweils einen ersten Endabschnitt und einen zweiten Endabschnitt aufweisen, zwischen denen jeweils ein zentraler Abschnitt angeordnet ist. Die Endabschnitte der mindestens zwei Stromschienen haben jeweils Anschlüsse zum Verbinden elektrischer Leiter mit der Filterkomponente. Der erste und der zweite Endabschnitt und der zentrale Abschnitt der ersten Stromschiene sind in einer ersten Ebene angeordnet, und der erste und der zweite Endabschnitt und der zentrale Abschnitt der mindestens einen zweiten Stromschiene sind in einer zweiten Ebene angeordnet, die unterschiedlich ist von der ersten Ebene. Dadurch kann die Filterkomponente aus Einbaurichtung an die elektrischen Leiter angeschlossen werden.

US2012/0081097 A1 offenbart eine Hochspannungs-Hochstromregler zum Regeln des Stroms, der zwischen einem ersten und einem zweiten Anschluss angeordnet ist, der mit einem externen Schaltkreis verbunden ist, und umfasst mindestens eine Hauptstrom tragende Kaltkathodenfeldemissionselektronenröhre, die den Strom zwischen dem ersten und dem zweiten Anschluss leitet.

Um derartige Funktionsstörungen durch die leitungsgebundenen und elektromagnetischen Emissionen zu verhindern, müssen parasitäre Induktionsströme, die in den Stromrichtern entstehen, rechtzeitig gefiltert werden, bevor diese Schäden anrichten können. Damit besteht die Aufgabe der vorliegenden Erfindung darin, eine Möglichkeit bereitzustellen, die parasitären Induktionsströme, die in den Stromrichtern, insbesondere in den Spannungswandlern, entstehen, effektiv zu filtern.

Diese Aufgabe wird durch den Gegenstand des unabhängigen Anspruchs gelöst. Vorteilhafte Ausgestaltungen sind Gegenstand der Unteransprüche.

Der Erfindung liegt der Gedanken zugrunde, dass die parasitären Induktionsströme hochfrequente Stromanteile in Nutzströmen ausbilden, die mithilfe einer Filteranordnung von den Nutzströmen getrennt und unschädlich gemacht werden können.

Im Rahmen der Erfindung wurde erkannt, dass hohe Impedanzen in einer Filteranordnung ein störender Faktor darstellen, die die Filtereigenschaft der Filteranordnung beeinträchtigen.

Mit dieser Erkenntnis wurde im Rahmen der Erfindung angestrebt, eine Lösung zu finden, mit der die Impedanzen in der Filteranordnung auf Minimum reduziert werden können.

Dabei wurde erkannt, dass die Impedanz eines Filterbauelements durch eine Anordnung des Filterbauelements unmittelbar zwischen einer stromführenden Leitung, durch die der Nutzstrom mit dem parasitären Induktionsstromanteil fließt, und elektrischer Masse erheblich reduzieren lässt.

So wurde eine Filteranordnung geschaffen, bei der das Filterbauelement unmittelbar zwischen der nutzstromführenden Stromschiene und dem Gehäuseteil angeordnet ist und mit der Stromschiene und dem Gehäuseteil direkt elektrisch verbunden ist, wobei das Gehäuseteil wiederum mittels eines am Gehäuseteil ausgebildeten elektrischen Massenanschlusses mit der elektrischen Masse unmittelbar elektrisch verbunden ist.

Die unmittelbare elektrische Verbindung des Filterbauelements zwischen der Stromschiene und dem unmittelbar an der elektrischen Masse elektrisch verbundenen Gehäuseteil ermöglicht einen sehr kurzen Stromflussweg von der Stromschiene über den Filterbauelement zu der elektrischen Masse, wodurch die Impedanz von der Stromschiene zu der elektrischen Masse auf Minimum reduziert werden kann.

Hierbei bedeutet das Wort "unmittelbar", dass die elektrische Verbindung von dem Gehäuseteil zu der elektrischen Masse ohne andere Schaltungskomponenten oder andere Gehäuseteile direkt mittels lediglich einer soliden mechanischen und elektrischen Verbindung erfolgt ist. Idealerweise wird der Boden des Hohlraums, in dem die Filteranordnung angeordnet ist, durch einen massiven Metallkörper gebildet, der elektrisch niederimpedant mit dem Bezugspotential, insbesondere Massepotential, des Fahrzeugs (Chassis) verbunden ist.

Durch die geringe Impedanz ist die parasitäre Induktivität in der Filteranordnung auf Minimum reduziert, wodurch wiederum die Filtereigenschaft der Filteranordnung erheblich verbessert wurde.

Damit ist eine Filteranordnung geschaffen, mit der die parasitären Induktionsströme in den Stromrichtern bzw. den Spannungswandlern effektiv gefiltert werden können.

Die Stromschiene und das Gehäuseteil funktionieren zudem als elektromagnetische Abschirmung für das Filterbauelement.

Die Filteranordnung umfasst ferner zumindest eine Abtrennwand aus elektrisch leitfähigem Material, die den Hohlraum in zumindest zwei Kammern unterteilt und die zumindest zwei Kammer voneinander elektromagnetisch isoliert. Dabei sind die Abtrennwände mit dem elektrischen Masseanschluss niederimpedant elektrisch leitend verbunden.

Vorzugsweise ist das zumindest eine Filterbauelement als ein Kondensator, insbesondere ein Keramikkondensator, ausgebildet.

Das zumindest eine Filterbauelement ist als ein SMD-Bauelement (ein oberflächenmontiertes Bauelement) ausgebildet. Dabei weist das zumindest eine Filterbauelement eine erste Bodenkontaktfläche und eine zweite Bodenkontaktfläche auf, die zur Bildung von elektrischen Kontakten ausgeführt sind. Über die erste Kontaktfläche ist das zumindest eine Filterbauelement mit dem Gehäuseteil und über die zweite Kontaktfläche mit der Stromschiene elektrisch leitend und mechanisch direkt angrenzend und flächig verbunden.

Die erste und die zweite Bodenkontaktfläche sind zwei elektrisch leitende niederohmige und flächig ausgedehnte Kontaktflächen, die auf zwei voneinander entgegengesetzte Oberflächen des Filterbauelements ausgebildet sind und analog zu dem Body- und Rückseitekontakt eines Nacktchips zur elektrischen Verbindung des Filterbauelements mit anderen Komponenten vorgesehen sind.

Hierbei bedeutet die Wortgruppe "direkt angrenzend", dass die elektrischen und mechanischen Verbindungen lediglich mittels einer soliden Schraubverbindung, einer Löt-/Schweißverbindung oder einer vergleichbaren stoffschlüssigen Verbindung direkt erfolgt sind und das Filterbauelement lediglich über diese stoffschlüssigen Verbindung an die Stromschiene bzw. den Gehäuseteil angrenzen.

Das Wort "flächig" bedeutet, dass die elektrischen und mechanischen Verbindungen über ausgedehnte Kontaktflächen zwischen dem Filterbauelement und der Stromschiene bzw. zwischen dem Filterbauelement und dem Gehäuseteil ausgebildet sind, die sich über die jeweiligen Bodenkontaktflächen des Filterbauelements ausdehnen.

Vorzugsweise weist das Gehäuseteil zumindest einen zur Stromschiene hin ragenden Vorsprung auf, über den das zumindest eine Filterbauelement mit dem Gehäuseteil elektrisch leitend und mechanisch verbunden ist. Alternativ oder zusätzlich zu dem zumindest einen Vorsprung am Gehäuseteil weist die Stromschiene zumindest einen zum Gehäuseteil hin ragenden Vorsprung auf, über den das zumindest eine Filterbauelement auch mit der Stromschiene elektrisch leitend und mechanisch verbunden ist.

Vorzugsweise umfasst die Filteranordnung ferner zumindest einen Ferritkörper, der die Stromschiene umgreift.

Vorzugsweise weist der zumindest eine Ferritkörper einen Luftspalt auf. Vorzugsweise ist der zumindest eine Ferritkörper über diesen Luftspalt in einfacher Weise an die Stromschiene gesteckt bzw. auf diese aufgesteckt. Insbesondere ist der zumindest eine Ferritkörper U-förmig ausgebildet.

Die Filteranordnung umfasst vorzugsweise zumindest zwei Filterbauelemente und/oder zumindest zwei Ferritkörper. Dabei sind die Filterbauelemente und die Ferritkörper zueinander in Richtung der Stromschiene abwechselnd angeordnet.

Damit bilden die Filterbauelemente und die Ferritkörper zusammen einen Tiefpassfilter in π-Topologie aus. Ferner werden hierdurch Hochfrequenzstromanteile über das Gehäuseteil zur elektrischen Masse abgeleitet.

Vorzugsweise weist die Stromschiene in Richtung der Stromschiene betrachtet einen rechteckigen Querschnitt auf.

Vorzugsweise sind die Ferritkörper in Richtung der Stromschiene betrachtet jeweils auf die Höhe der jeweiligen Abtrennwände angeordnet.

Dabei bilden jeweils eine Abtrennwand, jeweils ein Ferritkörper, der in Richtung der Stromschiene betrachtet sich auf die Höhe der entsprechenden Abtrennwand befindet, sowie Abschnitte der Stromschiene, die sich an der entsprechenden Abtrennwand und dem entsprechenden Ferritkörper angrenzen, vorzugsweise gemeinsam jeweils eine Filterstufe aus, die hochfrequente elektromagnetische Störungen filtert.

Gemäß einem weiteren Aspekt der Erfindung wird ein Stromrichter bereitgestellt. Dabei umfasst der Stromrichter zumindest ein Leistungsbauelement und zumindest eine zuvor beschriebene Filteranordnung, wobei die Stromschiene der zumindest einen Filteranordnung mit dem zumindest einen Leistungsbauelement elektrisch leitend verbunden ist.

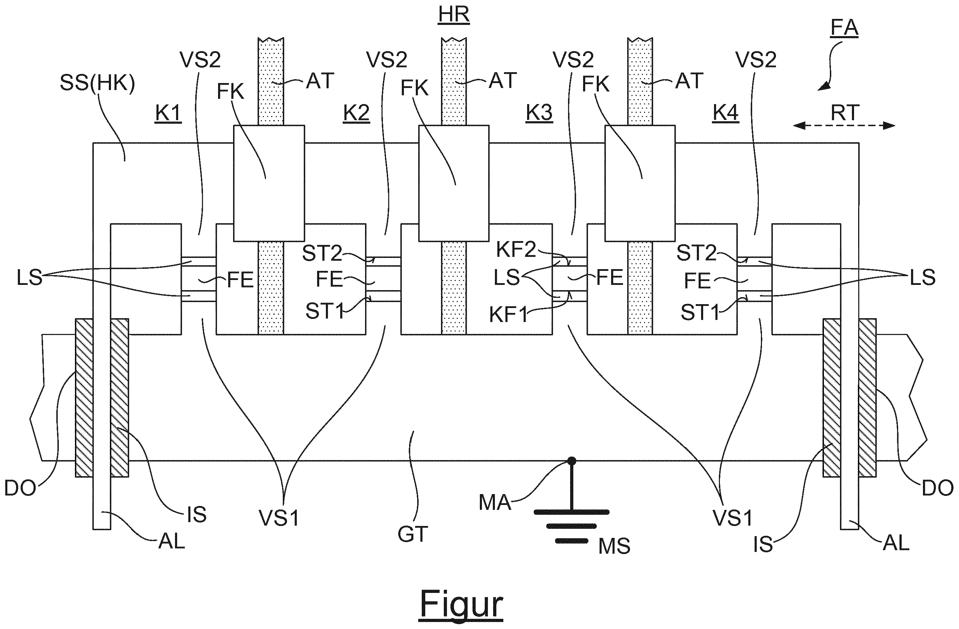

Im Folgenden wird eine beispielhafte Ausführungsform der Erfindung bezugnehmend auf eine Figur näher erläutert. Dabei zeigt die einzige Figur einen Abschnitt einer Filteranordnung FA eines Spanungswandlers eines Elekrofahrzeugs in schematischer Schnittdarstellung.

Die Filteranordnung FA umfasst ein Gehäuseteil GT, das überwiegend aus einem elektrisch leitenden Material, beispielsweise einer Aluminiumlegierung, besteht und insbesondere den Gehäuseboden des Gehäuses der Filteranordnung FA ausbildet. Das Gehäuseteil GT weist einen elektrischen Masseanschluss MA auf, über den das Gehäuseteil GT mit elektrischer Masse MS elektrisch leitend verbunden ist.

Das Gehäuseteil GT weist auf einer dem Hohlraum HR zugewandten Oberfläche vier Vorsprünge VS1 auf, die an dem Gehäuseteil GT in den Hohlraum HR bzw. zur Stromschiene SS hin ragend ausgebildet sind. Das Gehäuseteil GT weist ferner zwei Durchgangsöffnungen DO auf.

Das Gehäuseteil GT umschließt einen Hohlraum HR, in der eine Stromschiene SS angeordnet ist.

Die Stromschiene SS umfasst einen Hauptkörper HK, der im Wesentlichen, beziehungsweise zumindest stellenweise, geradlinig und länglich ausgebildet ist und in Richtung RT der Stromschiene SS betrachtet einen rechteckigen Querschnitt aufweist.

An den beiden axialen Enden des Hauptkörpers HK umfasst die Stromschiene SS jeweils eine Anschlusslasche AL, die senkrecht (beziehungsweise schräg) zu dem Hauptkörper HK ausgebildet und jeweils durch eine der beiden Durchgangsöffnungen DO an dem Gehäuseteil GT ins Gehäuseäußere geführt sind. Eine der beiden Anschlusslaschen AL bildet dabei einen Stromeingang aus und ist mit einem Leistungsschalter der in der Figur nicht dargestellten Leistungsendstufe des Spanungswandlers elektrisch leitend verbunden. Eine andere Anschlusslasche AL bildet analog einen Stromausgang aus und ist mit einer nachgeschalteten, in der Figur nicht dargestellten, elektrischen Schaltung elektrisch leitend verbunden. Damit dient die Filteranordnung FA zum Filtern von parasitären Induktionsströmen, die durch hochfrequentes Umschalten des Leistungsschalters in der Leistungsendstufe entstehen und schädlich für die nachgeschaltete elektrische Schaltung sind.

In der jeweiligen Durchgangsöffnung DO weist die Filteranordnung FA jeweils eine Isolierschicht IS auf, die die jeweilige durch die Durchgangsöffnung DO erstreckende Anschlusslasche AL ummantelt und somit diese bzw. die Stromschiene SS von dem Gehäuseteil GT elektrisch isoliert (Die Isolierschicht IS ist in der Figur schraffiert dargestellt).

Die Stromschiene SS weist ferner vier Vorsprünge VS2 auf, die an dem Hauptkörper HK zu dem Gehäuseteil GT hin ragend ausgebildet sind. Dabei sind die vier Vorsprünge VS2 an der Stromschiene SS jeweils mit einem der vier Vorsprünge VS1 an dem Gehäuseteil GT paarweise gegenüberstehend angeordnet.

Die Filteranordnung FA umfasst ferner drei Ferritkörper FK, die jeweils zwischen je zwei benachbarten Vorsprünge VS2 der Stromschiene SS angeordnet sind.

Dabei umschließen die Ferritkörper FK die Stromschiene SS und weisen jeweils einen Luftspalt auf, der den jeweiligen Ferritkörper FK an einer oder mehreren Stellen durchgehend trennt.

Über diesen Luftspalt sind die jeweiligen Ferritkörper die Stromschiene SS umgreifend an der Stromschiene SS gesteckt.

Die Filteranordnung FA umfasst ferner vier Filterbauelemente FE, die in dieser Ausführungsform als oberflächenmontierte Keramikkondensatoren (SMD-Keramikkondensatoren) ausgebildet sind.

Jeder der vier Keramikkondensatoren FE umfasst eine erste elektrische Bodenkontaktfläche KF1 und eine zweite elektrische Bodenkontaktfläche KF2, die auf zwei entgegengesetzt liegenden Oberflächen des jeweiligen Keramikkondensators FE ausgebildet sind.

Die vier Keramikkondensatoren FE sind jeweils zwischen einem Vorsprung VS1 des Gehäuseteils GT und einen diesem Vorsprung VS1 gegenüberliegenden Vorsprung VS2 der Stromschiene SS platziert. Dabei ist der Keramikkondensator FE über die erste Bodenkontaktfläche KF1 mittels einer Lötschicht LS mit der Stirnseite ST1 des Vorsprungs VS1 des Gehäuseteils GT elektrisch leitend und mechanisch verbunden.

Da es sich bei den bevorzugten Kondensatoren um SMD-Komponenten handelt, kann die Filteranordnung FA als mechanischen Träger dieser Komponenten auch eine Leiterplatte aufweisen.

Ferner ist der Keramikkondensator FE über die zweite Bodenkontaktfläche KF2 mittels einer weiteren Lötschicht LS mit der Stirnseite ST2 des Vorsprungs VS2 der Stromschiene SS elektrisch leitend und mechanisch verbunden.

Damit bilden die drei Ferritkörper FK und die vier Keramickondensatoren FE gemeinsam einen Tiefpass-Filter in diesem Fall in π-Topologie aus. Möglich ist auch eine T-Topologie.

Durch die direkte elektrische und mechanische Verbindung von den Keramikkondensatoren FE zwischen der Stromschiene SS und dem Gehäuseteil GT und somit der elektrischen Masse MS ist eine Filteranordnung FA mit einer sehr geringen Impedanz geschaffen, mit der die parasitären Induktionsströme, die in dem vorgeschalteten Leistungsschalter entstehen, effizient zu filtern, so dass eine Funktionsstörung bei der nachgeschalteten elektrischen Schaltung durch die parasitären Induktionsströme wirksam verhindert werden kann.

Zudem umfasst die Filteranordnung FA drei Abtrennwände AT, die den Hohlraum HR in vier Kammern K1, K2, K3 und K4 unterteilt. Dabei sind die Abtrennwände AT in Richtung RT der Stromschiene SS betrachtet jeweils auf die Höhe der jeweiligen Ferritkörper FK angeordnet, so dass in jeder der vier Kammer K1, K2, K3, K4 jeweils eine Filterstufe mit jeweils einem Filterbauelement FE ausbildet.

Dabei umfassen die Abtrennwände AT am Gehäuseteil GT angeformte massive Vorsprünge und zusätzlich eingebrachte Teile, die aus elektrisch leitfähigem Material wie Aluminium, Aluminiumlegierung, Kupfer, Kupferlegierung oder Stahllegierung, wie z. B. Weißblech bestehen und mit dem Gehäuseteil GT an möglichst vielen Stellen möglichst niederimpedant verbunden sind.

Die Kammer K1, K2, K3 und K4 sind durch die Abtrennwände AT voneinander elektromagnetisch abgeschirmt. Die elektromagnetischen Wellen, die sich aus den jeweiligen Filterbauelementen FE ausbreiten, werden von den jeweiligen Abtrennwänden AT blockiert und somit gelangen in die benachbarten Kammer K1, K2, K3 und K4 nicht.

Die Abtrennwände AT sind in Richtung RT der Stromschiene SS betrachtet jeweils auf die Höhen der jeweiligen Ferritkörper FK angeordnet und bilden jeweils gemeinsam mit je einem Ferritkörper FK und Abschnitten der Stromschiene SS, die sich an den jeweiligen Ferritkörpern FK angrenzen, je eine zusätzliche Filterstufe zum Filtern von hochfrequenten elektromagnetischen Störungen in dem durch die Stromschiene SS fließenden Strom.

## Patentansprüche

1. Filteranordnung (FA) zum Filtern von parasitären Induktionsströmen, die folgende Merkmale aufweist:
- ein elektrisch leitendendes Gehäuseteil (GT), das einen Hohlraum (HR) zumindest teilweise umschließt,
- einen elektrischen Masseanschluss (MA) an dem Gehäuseteil (GT) zur Bildung einer elektrischen Verbindung zu elektrischer Masse (MS),
- eine Stromschiene (SS) in dem Hohlraum (HR),
- zumindest ein elektrisches Filterbauelement (FE), das zwischen der Stromschiene (SS) und dem Gehäuseteil (GT) elektrisch angeschlossen und an dem Gehäuseteil (GT) und an der Stromschiene (SS) mechanisch befestigt ist;
- wobei die Filteranordnung (FA) ferner zumindest eine Abtrennwand (AT) aus elektrisch leitfähigem Material umfasst, die den Hohlraum (HR) in zumindest zwei Kammern (K1, K2, K3 und K4) unterteilt, wobei die zumindest eine Abtrennwand (AT) mit dem elektrischen Masseanschluss (MA) elektrisch leitend verbunden ist und die zumindest zwei Kammer (K1, K2, K3 und K4) voneinander elektromagnetisch isoliert,
**dadurch gekennzeichnet, dass**
- das zumindest eine Filterbauelement (FE) als SMD-Bauelement mit einer ersten elektrischen Bodenkontaktfläche (KF1) und einer zweiten elektrischen Bodenkontaktfläche (KF2) ausgebildet ist, und über die erste Bodenkontaktfläche (KF1) mit dem Gehäuseteil (GT) und über die zweite Bodenkontaktfläche (KF2) mit der Stromschiene (SS) elektrisch leitend, direkt angrenzend, flächig und mechanisch verbunden ist.

2. Filteranordnung (FA) nach Anspruch 1, wobei das zumindest ein Filterbauelement (FE) als ein Kondensator, insb. ein Keramikkondensator, ausgebildet ist.

3. Filteranordnung (FA) nach Anspruch 1 oder 2, wobei das Gehäuseteil (GT) zumindest einen zur Stromschiene (SS) hin ragenden Vorsprung (VS1) aufweist, über den das zumindest eine Filterbauelement (FE) mit dem Gehäuseteil (GT) elektrisch leitend und mechanisch verbunden ist, und/oder die Stromschiene (SS) zumindest einen zum Gehäuseteil (GT) hin ragenden Vorsprung (VS2) aufweist, über den das zumindest eine Filterbauelement (FE) mit der Stromschiene (SS) elektrisch leitend, direkt angrenzend, flächig und mechanisch verbunden ist.

4. Filteranordnung (FA) nach einem der vorangehenden Ansprüche, die ferner zumindest einen Ferritkörper (FK) umfasst, der die Stromschiene (SS) umgreift.

5. Filteranordnung (FA) nach Anspruch 4, wobei der zumindest eine Ferritkörper (FK) einen Luftspalt aufweist, und über diesen Luftspalt an der Stromschiene (SS) gesteckt ist.

6. Filteranordnung (FA) nach Anspruch 4 oder 5, die zumindest zwei Filterbauelemente (FE) und/oder zumindest zwei Ferritkörper (FK) umfasst, wobei die Filterbauelemente (FE) und die Ferritkörper (FK) zueinander in Richtung (RT) der Stromschiene (SS) abwechselnd angeordnet sind.

7. Filteranordnung (FA) nach einem der Ansprüche 4 bis 6, wobei die Ferritkörper (FK) in Richtung (RT) der Stromschiene (SS) betrachtet jeweils auf die Höhe der jeweiligen Abtrennwände (AT) angeordnet sind.

8. Filteranordnung (FA) nach Anspruch 7, wobei jeweils eine Abtrennwand (AT), jeweils ein Ferritkörper (FK) sowie Abschnitte der Stromschiene SS, die sich an der jeweiligen Abtrennwand (AT) und dem jeweiligen Ferritkörper (FK) angrenzen, gemeinsam jeweils eine Filterstufe zum Filtern von hochfrequenten elektromagnetischen Störungen ausbilden.

9. Spannungswandler, der zumindest ein Leistungsbauelement und zumindest eine Filteranordnung (FA) nach einem der vorangehenden Ansprüche umfasst, wobei die Stromschiene (SS) der Filteranordnung (FA) mit dem Leistungsbauelement elektrisch leitend verbunden ist.

## Claims

1. Filter arrangement (FA) for filtering parasitic induction currents, which filter arrangement has the following features:
- an electrically conductive housing part (GT) which at least partially encloses a cavity (HR),
- an electrical ground connection (MA) on the housing part (GT) for forming an electrical connection to electrical ground (MS),
- a busbar (SS) in the cavity (HR),
- at least one electrical filter component (FE) which is electrically connected between the busbar (SS) and the housing part (GT) and which is mechanically fastened to the housing part (GT) and to the busbar (SS) ;
- wherein the filter arrangement (SA) furthermore comprises at least one partition (AT) which is composed of electrically conductive material and which divides the cavity (HR) into at least two chambers (K1, K2, K3 and K4), wherein the at least one partition (AT) is connected in electrically conductive fashion to the electrical ground connection (MA) and electromagnetically isolates the at least two chambers (K1, K2, K3 and K4) from one another,
**characterized in that**
- the at least one filter component (FE) is formed as an SMD component with a first electrical base contact surface (KF1) and a second electrical base contact surface (KF2) and is connected in electrically conductive, directly adjoining, areal and mechanical fashion by way of the first base contact surface (KF1) to the housing part (GT) and by way of the second base contact surface (KF2) to the busbar (SS).

2. Filter arrangement (FA) according to Claim 1, wherein the at least one filter component (FE) is formed as a capacitor, in particular a ceramic capacitor.

3. Filter arrangement (FA) according to Claim 1 or 2, wherein the housing part (GT) has at least one projection (VS1) which projects towards the busbar (SS) and by means of which the at least one filter component (FE) is connected in electrically conductive and mechanical fashion to the housing part (GT), and/or the busbar (SS) has at least one projection (VS2) which projects towards the housing part (GT) and by means of which the at least one filter component (FE) is connected in electrically conductive, directly adjoining, areal and mechanical fashion to the busbar (SS).

4. Filter arrangement (FA) according to any of the preceding claims, which furthermore comprises at least one ferrite body (FK) which engages around the busbar (SS).

5. Filter arrangement (FA) according to Claim 4, wherein the at least one ferrite body (FK) has an air gap and is fitted on the busbar (SS) by way of said air gap.

6. Filter arrangement (FA) according to Claim 4 or 5, which comprises at least two filter components (FE) and/or at least two ferrite bodies (FK), wherein the filter components (FE) and the ferrite bodies (FK) are arranged so as to alternate with one another in a direction (RT) of the busbar (SS).

7. Filter arrangement (FA) according to any of Claims 4 to 6, wherein the ferrite bodies (FK) are, as viewed in the direction (RT) of the busbar (SS), arranged in each case at the level of the respective partitions (AT).

8. Filter arrangement (FA) according to Claim 7, wherein in each case one partition (AT), in each case one ferrite body (FK) and portions of the busbar (SS) which adjoin the respective partition (AT) and the respective ferrite body (FK) jointly form in each case one filter stage for the filtering of high-frequency electromagnetic disturbances.

9. Voltage converter which comprises at least one power component and at least one filter arrangement (FA) according to any of the preceding claims, wherein the busbar (SS) of the filter arrangement (FA) is connected in electrically conductive fashion to the power component.

## Revendications

1. Ensemble de filtrage (FA) pour le filtrage de courants d'induction parasites, présentant les particularités suivantes :
- une partie de boîtier électroconductrice (GT) qui englobe au moins en partie une cavité (HR),
- une connexion électrique à la masse (MA) sur la partie de boîtier (GT) afin de former une liaison électrique à une masse électrique (MS),
- un rail conducteur (SS) dans la cavité (HR),
- au moins un composant de filtrage électrique (FE) qui est connecté électriquement entre le rail conducteur (SS) et la partie de boîtier (GT) et fixé mécaniquement à la partie de boîtier (GT) et au rail conducteur (SS) ;
- dans lequel l'ensemble de filtrage (FA) comprend en outre au moins une cloison de séparation (AT) en matériau électroconducteur, qui divise la cavité (HR) en au moins deux chambres (K1, K2, K3 et K4), ladite au moins une cloison de séparation (AT) étant reliée de manière électroconductrice à la connexion électrique à la masse (MA) et isolant de manière électromagnétique les au moins deux chambres (K1, K2, K3 et K4) les unes par rapport aux autres,
**caractérisé en ce que**
- ledit au moins un composant de filtrage (FE) est réalisé sous la forme d'un composant SMD muni d'une première surface de contact au sol électrique (KF1) et d'une deuxième surface de contact au sol électrique (KF2), et est relié de manière électroconductrice, immédiatement adjacente, plane et mécanique à la partie de boîtier (GT) par l'intermédiaire de la première surface de contact au sol (KF1) et au rail conducteur (SS) par l'intermédiaire de la deuxième surface de contact au sol (KF2).

2. Ensemble de filtrage (FA) selon la revendication 1, dans lequel ledit au moins un composant de filtrage (FE) est réalisé sous la forme d'un condensateur, en particulier d'un condensateur en céramique.

3. Ensemble de filtrage (FA) selon la revendication 1 ou 2, dans lequel la partie de boîtier (GT) présente au moins une saillie (VS1) dépassant en direction du rail conducteur (SS) et par laquelle ledit au moins un composant de filtrage (FE) est relié de manière électroconductrice et mécanique à la partie de boîtier (GT), et/ou le rail conducteur (SS) présente au moins une saillie (VS2) dépassant en direction de la partie de boîtier (GT) et par laquelle ledit au moins un composant de filtrage (FE) est relié au rail conducteur (SS) de manière électroconductrice, immédiatement adjacente, plane et mécanique.

4. Ensemble de filtrage (FA) selon l'une quelconque des revendications précédentes, comprenant en outre au moins un corps en ferrite (FK) englobant le rail conducteur (SS).

5. Ensemble de filtrage (FA) selon la revendication 4, dans lequel ledit au moins un corps en ferrite (FK) présente un entrefer et est enfiché sur le rail conducteur (SS) par l'intermédiaire de cet entrefer.

6. Ensemble de filtrage (FA) selon la revendication 4 ou 5, comprenant au moins deux composants de filtrage (FE) et/ou au moins deux corps en ferrite (FK), les composants de filtrage (FE) et les corps en ferrite (FK) étant disposés en alternance les uns avec les autres dans la direction (RT) du rail conducteur (SS).

7. Ensemble de filtrage (FA) selon l'une quelconque des revendications 4 à 6, dans lequel les corps en ferrite (FK) sont disposés respectivement au niveau des cloisons de séparation (AT) respectives, vus dans la direction (RT) du rail conducteur (SS).

8. Ensemble de filtrage (FA) selon la revendication 7, dans lequel respectivement une cloison de séparation (AT), respectivement un corps en ferrite (FK) ainsi que des portions du rail conducteur SS qui sont adjacentes à la cloison de séparation (AT) respective et au corps en ferrite (FK) respectif, réalisent ensemble respectivement un étage de filtrage pour filtrer des perturbations électromagnétiques haute fréquence.

9. Convertisseur de tension comprenant au moins un composant de puissance et au moins un ensemble de filtrage (FA) selon l'une quelconque des revendications précédentes, dans lequel le rail conducteur (SS) de l'ensemble de filtrage (FA) est relié de manière électroconductrice au composant de puissance.
